# EUROPEAN PATENT APPLICATION

(11) **EP 2 688 370 A1**
(43) Date of publication of application: **22.01.2014**
(21) Application number: 12758371.4
(22) Date of filing: 09.03.2012
(51) Int. Cl.: H05B 33/12, H01L 51/50

(54) **ORGANIC ELECTROLUMINESCENT ELEMENT**

(30) Priority: 14.03.2011 JP 2011055866
(71) Applicant: Idemitsu Kosan Co., Ltd., Chiyoda-ku Tokyo 100-8321 (JP)
(72) Inventor: ENDO Jun, Sodegaura-shi, Chiba 299-0293 (JP)
(74) Representative: Gille Hrabal
(86) International application number: PCT/JP2012/056195
(87) International publication number: WO 2012/124642

(57) **Abstract**

A tandem-type organic electroluminescence device (1) includes an anode (12), a cathode (16) opposed to the anode (12), and at least a first emitting unit (13) and a second emitting unit (15). An intermediate unit (14) is provided between the first emitting unit (13) and the second emitting unit (15). The intermediate unit (14) includes an inorganic-compound-containing layer (141) and a metal layer (142) which are laminated in this sequence from the anode (12). The inorganic-compound-containing layer (141) includes calcium halide.

## Description

### TECHNICAL FIELD

The present invention relates to an organic electroluminescence device.

### BACKGROUND ART

There has been known an organic electroluminescence device (hereinafter, referred to as an "organic EL device") that includes an emitting unit (in which an emitting layer is included) between an anode and a cathode and emits light using exciton energy generated by a recombination of holes and electrons that have been injected into the emitting layer.

Recently, an arrangement of the organic EL device having a plurality of emitting units laminated via an intermediate unit and connected in series has been studied for improving luminous efficiency and lifetime of the organic EL device. Such a device arrangement is called a tandem-type.

The tandem-type organic EL device requires holes or electrons to be injected from the intermediate unit to the adjacent emitting units. Accordingly, the intermediate unit is required to have a function for generating the holes and the electrons as well as injecting the generated holes and electrons to each of the adjacent emitting units.

From such a background, various studies regarding the intermediate unit have been made.

For instance, an intermediate unit of an organic EL device disclosed in Patent Literature 1 is provided by inserting a transparent conductive film such as ITO and IZO (registered trademark) between an electron injecting layer and a hole injecting layer, and generates and injects charges to the respective emitting units.

Patent Literature 2 discloses a tandem-type organic EL display having an intermediate electrode between two organic layers including an emitting layer in which a metal material such as aluminium and silver-magnesium alloy as well as ITO is usable as the intermediate electrode.

However, since film formation by sputtering is typically required for forming a transparent conductive film, it is pointed out that an organic film is damaged due to influences by secondary electrons generated during the film formation process.

Further, only an insertion of a metal layer or a conductive oxide layer into the intermediate unit as proposed in Patent Literatures 1 and 2 is insufficient for injecting holes and electrons to the emitting unit, so that drive voltage is increased and luminous efficiency is decreased.

Accordingly, for instance, in Patent Literature 3, an electron injecting layer formed of lithium fluoride (LiF), which is generally used in a typical single unit-type organic EL device, and a cathode formed of aluminium (Al) are employed in an attempt to promote injection of holes and electrons to the emitting unit. In the tandem-type organic EL device disclosed in Patent Literature 3, a thickness of the aluminium layer is 1 nm in order to ensure light transmission properties. It should be noted that a single unit-type organic EL device refers to an organic EL device provided with a single emitting unit unlike a tandem-type organic EL device.

### CITATION LIST

### PATENT LITERATURE(S)

Patent Literature 1: JP-A-11-329748
Patent Literature 2: JP-A-11-329749
Patent Literature 3: JP-A-2010-192719

### SUMMARY OF THE INVENTION

### PROBLEMS TO BE SOLVED BY THE INVENTION

However, in a practical luminescence intensity, drive voltage is raised.

An object of the invention is to provide a tandem-type organic EL device that favorably injects holes and electrons to emitting units and exhibits a low drive voltage and a high luminous efficiency.

### MEANS FOR SOLVING THE PROBLEMS

After dedicated study to solve the above problem, the inventors found that drive voltage is decreased and luminous efficiency is improved by laminating an inorganic-compound-containing layer containing calcium halides, a metal layer, and preferably an electron accepting material, between emitting units, and reached the invention.

A tandem-type organic electroluminescence device according to an aspect of the invention including: an anode; a cathode opposed to the anode; at least a first emitting unit and a second emitting unit provided between the anode and the cathode, and an intermediate unit provided between the first emitting unit and the second emitting unit, in which the intermediate unit comprises an inorganic-compound-containing layer and a metal layer sequentially layered from the anode, and the inorganic compound-containing layer includes calcium halide.

An organic electroluminescence device according to another aspect of the invention including: an anode; a cathode opposed to the anode; a first emitting unit provided between the anode and the cathode, a second emitting unit provided between the anode and the cathode, and an intermediate unit provided between the first emitting unit and the second emitting unit, in which the intermediate unit includes an inorganic-compound-containing layer and a metal layer in this sequence from the anode, and the inorganic-compound-containing layer includes at least one calcium halide selected from the group consisting of calcium fluoride, calcium chloride and calcium bromide.

In the organic electroluminescence device according to the above aspect of the invention, preferably, the second emitting unit is provided adjacent to the intermediate unit near the cathode, the intermediate unit further includes a hole injecting layer between the metal layer and the second emitting unit, the hole injecting layer is adjacent to the metal layer and the second emitting unit, and the hole injecting layer includes an organic compound having an electron accepting group.

In the organic electroluminescence device according to the above aspect of the invention, the hole injecting layer is preferably at least one of a carbon layer in an amorphous state and a carbon layer substituted by fluorine.

In the organic electroluminescence device according to the above aspect of the invention, the carbon layer is preferably formed by reactive sputtering.

In the organic electroluminescence device according to the above aspect of the invention, the carbon layer substituted by fluorine is preferably formed by plasma polymerization.

In the organic electroluminescence device according to the above aspect of the invention, the metal layer is preferably formed of metal capable of thermally reducing the inorganic-compound-containing layer in a vacuum.

In the organic electroluminescence device according to the above aspect of the invention, the metal layer is preferably formed of metal selected from aluminium, magnesium and an alloy thereof.

In the organic electroluminescence device according to the above aspect of the invention, the metal layer is preferably formed on the inorganic compound-containing layer by vapor deposition.

According to the above aspect of the invention, a tandem-type organic EL device having a low drive voltage and a high luminous efficiency can be provided.

### BRIEF DESCRIPTION OF DRAWING

Fig. 1 schematically shows an exemplary arrangement of an organic EL device according to a first exemplary embodiment of the invention.
Fig. 2 schematically shows an exemplary arrangement of an organic EL device according to a second exemplary embodiment of the invention.
Fig. 3 schematically shows a cross section seen in a thickness direction of a substrate of an organic EL device according to a third exemplary embodiment of the invention.

### DESCRIPTION OF EMBODIMENTS

### First Exemplary Embodiment

### Arrangement of Organic EL Device

A tandem-type organic EL device includes a plurality of emitting units, e.g., a first emitting unit and a second emitting unit, as follows: anode / first emitting unit / intermediate unit / second emitting unit / cathode.

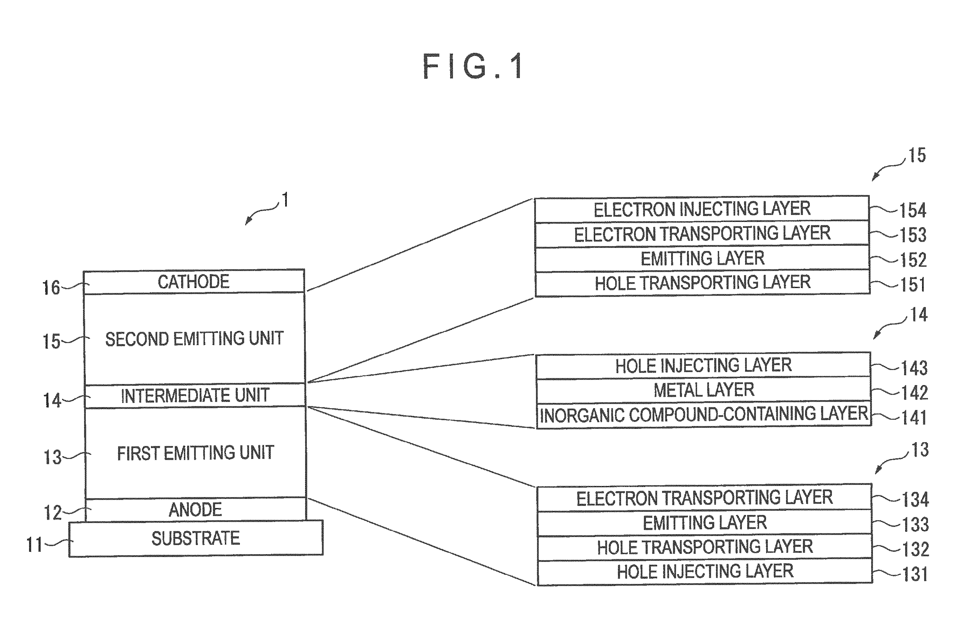

In the first exemplary embodiment, a tandem-type organic EL device 1 arranged as shown in Fig. 1 is exemplarily described. The organic EL device 1 is provided by laminating an anode 12, a first emitting unit 13, an intermediate unit 14, a second emitting unit 15 and a cathode 16 on a substrate 11 in this sequence. As shown in Fig. 1, the first emitting unit 13, the intermediate unit 14 and the second emitting unit 15 are respectively provided with a plurality of layers. The arrangements thereof are as follows.

The first emitting unit 13 includes a hole injecting layer 131, a hole transporting layer 132, an emitting layer 133, and an electron layer 134.

The intermediate unit 14 includes an inorganic-compound-containing layer 141, a metal layer 142, and a hole injecting layer 143.

The second emitting unit 15 includes a hole transporting layer 151, an emitting layer 152, an electron transporting layer 153, and an electron injecting layer154.

The units and the layers each will be described in detail below.

### Intermediate Unit

The intermediate unit injects electrons to the first emitting unit and injects holes to the second emitting unit. The intermediate unit includes an inorganic-compound-containing layer, a metal layer and a hole injecting layer in this sequence from the anode.

### Inorganic-Compound-Containing Layer

An inorganic-compound-containing layer injects electrons to the first emitting unit.

The inorganic-compound-containing layer is adjacent to the metal layer while being adjacent to the first emitting unit. In the organic EL device 1, the inorganic-compound-containing layer 141 is adjacent to the metal layer 142 while being adjacent to the electron transporting layer 134 of the first emitting unit 13.

The inorganic-compound-containing layer includes a calcium halide. Examples of the calcium halide include calcium fluoride (CaF₂), calcium chloride (CaCl₂) and calcium bromide (CaBr₂), among which CaF₂ is preferable.

The calcium halide may be used alone or a plurality of calcium halides may be used in a mixture. Further, the calcium halide may be blended with an organic substance.

The inorganic-compound-containing layer of the invention is substantially formed of such a calcium halide and may contain a component that does not affect operation and effects of the invention. In other words, the inorganic-compound-containing layer of the invention may also contain substances other than the calcium halide (e.g., a quite small amount of impure substances) as long as characteristics of the calcium halide are not hampered.

The inorganic-compound-containing layer can be formed by resistance heating deposition and electron beam vapor deposition, thereby restraining damages on an organic compound layer adjacent to the inorganic-compound-containing layer. Examples of the organic compound layer include an electron injecting layer and an electron transporting layer. The organic compound layer of the organic EL device 1 is the electron transporting layer 134. For instance, in film-formation of the transparent conductive oxides such as ITO on the organic compound layer, a sputtering process is typically required. Consequently, damages to the organic compound layer by plasma are unavoidable.

A thickness of the inorganic-compound-containing layer is preferably in a range from 1 nm to 50 nm, more preferably in a range from 1 nm to 10 nm.

### Metal Layer

The metal layer thermally reduces an alkaline-earth metal halide of the inorganic-compound-containing layer.

Metal forming the metal layer is preferably aluminium (Al), magnesium (Mg), calcium (Ca) and the like, among which aluminium and magnesium are more preferable.

The metal may be formed by one kind of metal or by plural kinds of metals in combination. When the plural kinds of metals are mixed, the metals include an alloy. The alloy is preferably a magnesium-silver alloy (Mg-Ag alloy), a magnesium-aluminium alloy (Mg-Al alloy) and a calcium-silver alloy (Ca-Ag alloy).

The metal of the metal layer is preferably a metal exhibiting standard reaction Gibbs energy in a halogenation reaction in a vacuum lower than standard reaction Gibbs energy in a halogenation reaction of calcium in a vacuum. Examples of the metal include aluminium, magnesium and an alloy thereof.

The metal layer of the invention is substantially formed of such metals and may contain a component that does not affect operation and effects of the invention. In other words, the metal layer of the invention may also contain substances other than the metal (e.g., a quite small amount of impure substances) as long as characteristics of the metal are not hampered.

A thickness of the metal layer is preferably in a range from 1 nm to 20 nm, more preferably in a range from 1 nm to 5 nm. The above range of the thickness of the metal layer is preferable since the metal layer exhibits a high transmittance to allow light generated from the emitting unit to be effectively extracted through the metal layer.

The tandem-type organic EL device provided with the above intermediate unit exhibits a low drive voltage and a high luminous efficiency.

Here, a description will be made on a significant difference in the above properties of the organic EL device between when the calcium halide is used in the inorganic-compound-containing layer of the intermediate unit as in the invention and when an alkali metal fluoride (e.g., lithium fluoride (LiF)) generally used as the electron injecting layer in a typical single unit-type organic EL device.

In the single unit-type organic EL device, a metal layer as an electrode is laminated on the electron injecting layer formed of the alkali metal fluoride (e.g., lithium fluoride). The metal layer as the electrode is, for instance, formed in vapor deposition in a thickness of about 100 nm. During formation of the metal layer, since the alkali metal fluoride is thermally reduced, an elementary substance of the alkali metal becomes present in the electron injecting layer, thereby improving electron injectability of the electron injecting layer.

When a laminate arrangement of the layer formed of the alkali metal fluoride (e.g., LiF) and the metal layer in the single unit-type organic EL device is used for the intermediate unit of the tandem-type organic EL device, the intermediate unit is also required to have light transmittance property, so that the thickness of the metal layer needs to be formed small enough to provide light transmittance property, for instance, to be formed as thin as about several nm. In other words, unlike the single unit-type organic EL device, the metal layer cannot be formed thick in vapor deposition.

For instance, a thermal reduction reaction between calcium fluoride and lithium fluoride is represented as follows.

3LiF+Al → 3Li+AlF₃

(3/2)CaF₂+Al → (3/2)Ca+AlF₃

As understood from the reaction formulae, per unit molecule of each of the fluorides used in the thermal reduction reaction with aluminium, lithium fluoride has the larger number of molecules than calcium fluoride. However, with respect to the mole number of each of the fluorides present per unit thickness, the mole number of lithium fluoride is 2.5 times as large as that of calcium fluoride. Accordingly, in order to reduce each of the fluorides per unit thickness, lithium fluoride requires more aluminium than calcium fluoride.

Accordingly, when a thin film metal layer of lithium fluoride is thermally reduced, lithium fluoride in the electron injection layer is not completely thermally reduced to remain in the thin film metal layer. The remaining lithium fluoride inhibits electron injection from the intermediate unit, so that the drive voltage of the device is increased and the luminous efficiency thereof is decreased.

On the other hand, calcium halide, which is thermally reduced more easily than the alkali metal fluoride, is used in the inorganic-compound-containing layer of the intermediate unit of the invention. Accordingly, even when the metal layer is formed in a thin film on the inorganic-compound-containing layer, calcium is reduced and exists as an elementary substance of alkaline earth metal in the electron injecting layer. Consequently, electron injectability from the intermediate unit is improved, so that the drive voltage of the device is decreased and the luminous efficiency thereof is increased.

### Hole Injecting Layer in Intermediate Unit

When voltage is applied on the organic EL device, the hole injecting layer in the intermediate unit injects holes to the second emitting unit.

The hole injecting layer in the intermediate unit of the invention contains an organic electron accepting material. The organic electron accepting material is an organic compound including an electron accepting group. Particularly, the organic electron accepting material is preferably a fused aromatic compound and a heterocyclic compound, which include an electron accepting group. The hole injecting layer in the intermediate unit is preferably formed of the organic compound only.

Examples of the electron accepting group are a nitro group, imino group, cyano group, carbonyl group and halogen group. The hole injecting layer of the intermediate unit injects the holes to the second emitting unit by receiving the electrons from the second emitting unit adjacent to the electron injecting layer.

The organic electron accepting material used for the hole injecting layer in the intermediate unit is preferably a compound represented by the following formula (1).

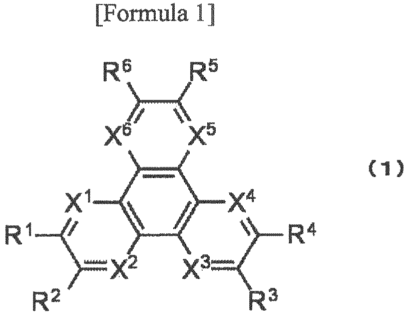

In the formula (1), R¹ to R⁶ are a substituent selected from the group consisting of hydrogen, halogen, a hydroxyl group, an amino group, an arylamino group, a carbonyl group having at most 20 carbon atoms, a carbonylester group having at most 20 carbon atoms, an alkyl group having at most 20 carbon atoms, an alkenyl group having at most 20 carbon atoms, an alkoxyl group having at most 20 carbon atoms, an aryl group having at most 30 carbon atoms, a heterocyclic group having at most 30 carbon atoms, a nitrile group, a nitro group, a cyano group, or a silyl group.
R¹ to R⁶ may be the same or different. The carbonyl group, carbonylester group, alkyl group, alkenyl group, alkoxyl group, aryl group and heterocyclic group may be substituted.

In the formula (1), among R^{m} (m = 1 to 6), adjacent R^{m} may be bonded to each other through a cyclic structure.
X¹ to X⁶ are a carbon atom or a nitrogen atom. X¹ to X⁶ may be the same or different.

A compound represented by the following formula (2) is preferable among the organic compounds represented by the formula (1).

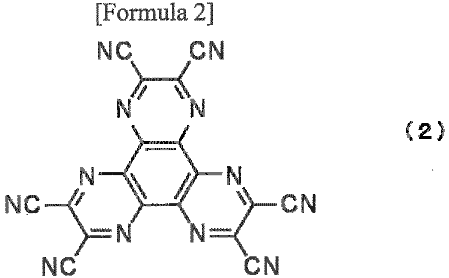

A compound represented by the following formula (3) is also preferably used as the organic electron accepting material used for the hole injecting layer.

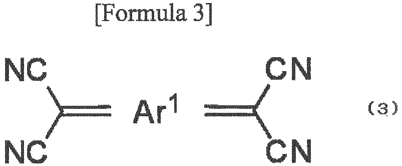

In the formula (3), Ar¹ is an organic group that can be substituted by halogen or a CN group. Examples of the organic group are listed below.

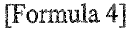

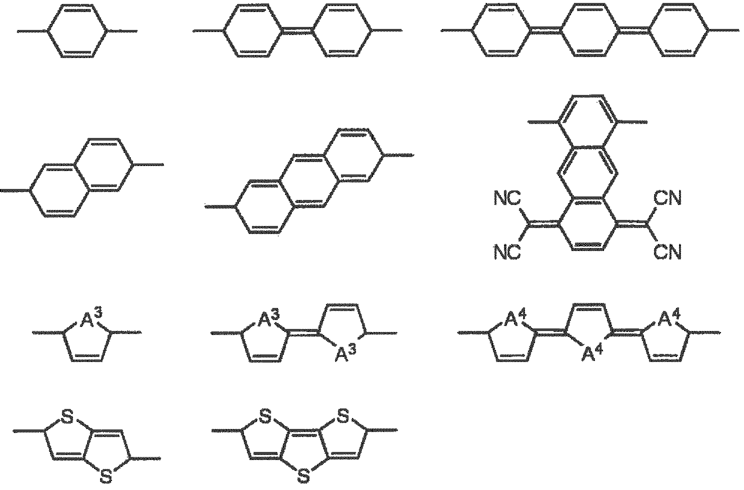

In the organic group, A³ is an oxygen atom, a sulfur atom, or a selenium atom and may be mutually the same or different.

In the organic group, A⁴ is a sulfur atom or a selenium atom and may be mutually the same or different.

Further, compounds represented by the following formulae (4) to (6) are also preferably used as the organic electron accepting material used for the hole injecting layer.

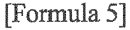

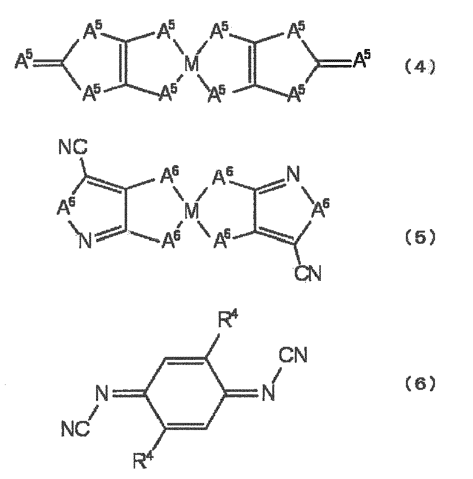

In the formulae (4) to (6), A⁵ is a carbon atom, a sulfur atom, a selenium atom, a tellurium atom or an oxygen atom and may be mutually the same or different.

A⁶ is a carbon atom, a sulfur atom, a selenium atom or a tellurium atom and may be mutually the same or different.

M is a nickel atom, a palladium atom, a platinum atom, or a zinc atom.

R⁴ is a hydrogen atom, a halogen atom, an alkyl group having 1 to 50 carbon atoms or an alkoxy group having 1 to 50 carbon atoms and may be mutually the same or different.

Specific examples of the compounds represented by the formulae (3) to (6) are the following organic materials and compounds obtained by substituting the organic materials with halogen or the CN group.

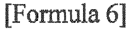

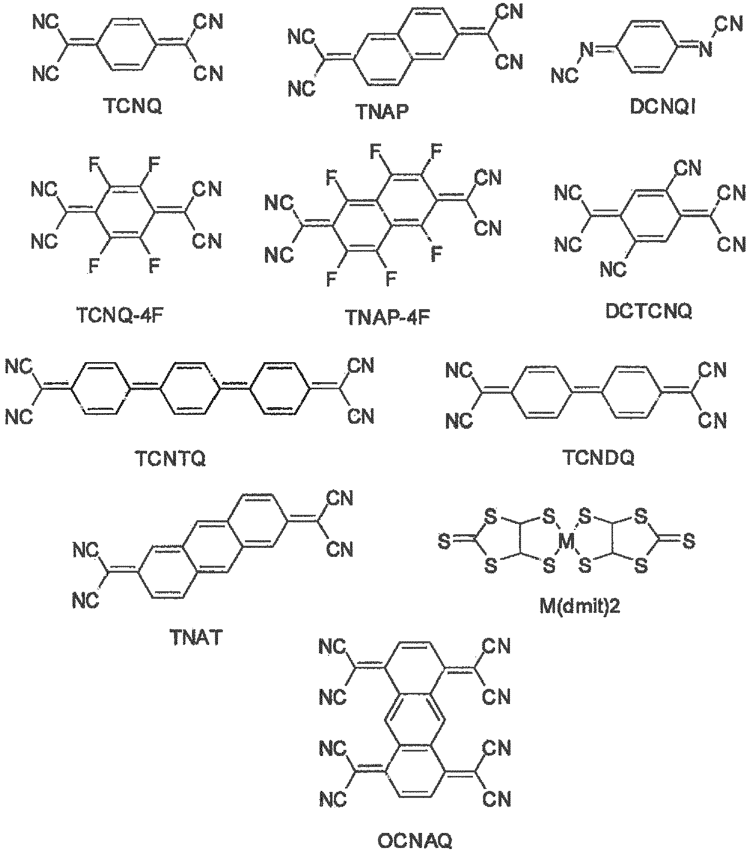

In addition, as the organic electron receiving material used for the hole injecting layer in the intermediate unit, an indenofluorenedione derivative disclosed in International Publication No. WO 2009/011327, an azaindenofluorenedione derivative disclosed in International Publication No. WO 2009/069717 and an indenofluorenedione derivative disclosed in International Publication No. WO 2010/064655 (PCT/JP2009/070243) are also preferably used. These derivatives are shown in the following formulae (I).

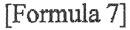

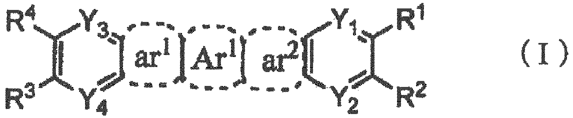

In the formula (I), Ar¹ is a fused ring having 6 to 24 carbon atoms forming a ring (hereinafter, referred to as "ring carbon atoms") or a heterocyclic ring having 6 to 24 atoms forming a ring (hereinafter, referred to as "ring atoms"). ar¹ and ar² may be mutually the same or different. ar¹ and ar² are represented by the following formula (i) or (ii).

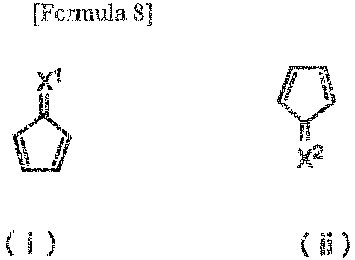

In the formula (i) or (ii), X¹ and X² may be mutually the same or different. X¹ and X² are any one of divalent groups represented by the following formulae (a) to (g).

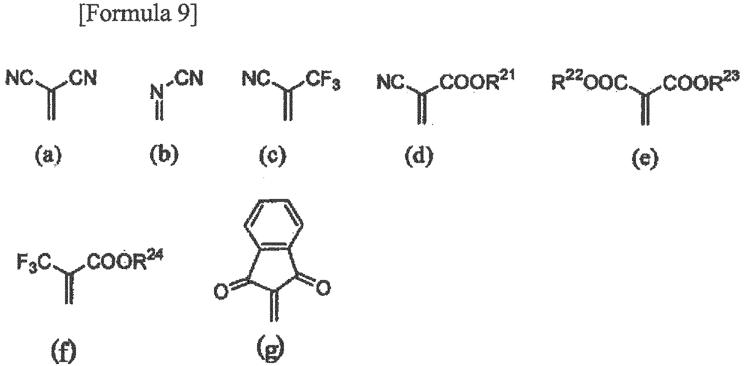

In the formulae (a) to (g), R²¹ to R²⁴ may be mutually the same or different and are a hydrogen atom, a fluoroalkyl group, an alkyl group, an aryl group or a heterocyclic group.

Herein, R²² and R²³ in the above formulae (a) to (g) may be bonded to each other to form a ring. The fluoroalkyl group, the alkyl group, the aryl group and the heterocyclic group in R²¹ to R²⁴ may be substituted.

In the formula (I), R¹ to R⁴ may be mutually the same or different.

R¹ to R⁴ are a hydrogen atom, an alkyl group, an aryl group, a heterocyclic group, a halogen atom, a fluoroalkyl group, an alkoxy group, an aryloxy group or a cyano group.

Herein, among R¹ to R⁴ in the formula (I), adjacent groups may be bonded to each other to form a ring. The fluoroalkyl group, the alkyl group, the aryl group and the heterocyclic group in R¹ to R⁴ of the formula (I) may be substituted.

In the formula (I), Y₁ to Y₄ may be mutually the same or different and are -N-, - CH= or -C(R⁵)=. Herein, R⁵ is an alkyl group (which may be substituted), an aryl group, a heterocyclic group, a halogen atom, a fluoroalkyl group, an alkoxy group, an aryloxy group or a cyano group. The aryl group and the heterocyclic group in R⁵ may be substituted.

The hole injecting layer may contain an amine compound and a fused cyclic compound in addition to the organic electron accepting material. Herein, a blending ratio of the amine compound and the fused cyclic compound to the organic electron accepting material is preferably 1:99 to 50:50 by a mass ratio, more preferably 1:99 to 10:90.

### Amine Compound

The amine compound is preferably exemplified by an aromatic amine compound.

The aromatic amine compound is preferably an aromatic amine derivative represented by the following formula (Al).

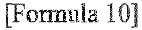

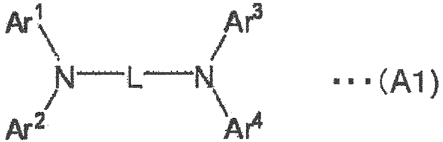

In the formula (Al), Ar¹ to Ar⁴ represent an aromatic hydrocarbon group having 6 to 50 ring carbon atoms, a fused aromatic hydrocarbon group having 6 to 50 ring carbon atoms, an aromatic heterocyclic group having 2 to 40 ring carbon atoms, a fused aromatic heterocyclic group having 2 to 40 ring carbon atoms, a group provided by bonding the aromatic hydrocarbon group and the aromatic heterocyclic group, a group provided by bonding the aromatic hydrocarbon group and the fused aromatic heterocyclic group, a group provided by bonding the fused aromatic hydrocarbon group and the aromatic heterocyclic group, and a group provided by bonding the fused aromatic hydrocarbon group and the fused aromatic heterocyclic group.

Note that the aromatic hydrocarbon group, the fused aromatic hydrocarbon group, the aromatic heterocyclic group and the fused aromatic heterocyclic group described herein may have a substituent.

In the formula (Al), L is a linking group and represents a divalent aromatic hydrocarbon group having 6 to 50 ring carbon atoms, a divalent fused aromatic hydrocarbon group having 6 to 50 ring carbon atoms, a divalent aromatic heterocyclic group having 5 to 50 ring carbon atoms, a divalent fused aromatic heterocyclic group having 5 to 50 ring carbon atoms, and a divalent group provided by bonding two or more aromatic hydrocarbon groups or aromatic heterocyclic groups with a single bond, an ether bond, a thioether bond, an alkylene group having 1 to 20 carbon atoms, an alkenylene group having 2 to 20 carbon atoms or an amino group. Note that the divalent aromatic hydrocarbon group, the divalent fused aromatic hydrocarbon group, the divalent aromatic heterocyclic group and the divalent fused aromatic heterocyclic group described herein may have a substituent.

Examples of the compound represented by the formula (Al) are shown below, but the compound represented by the formula (A1) is not limited thereto.

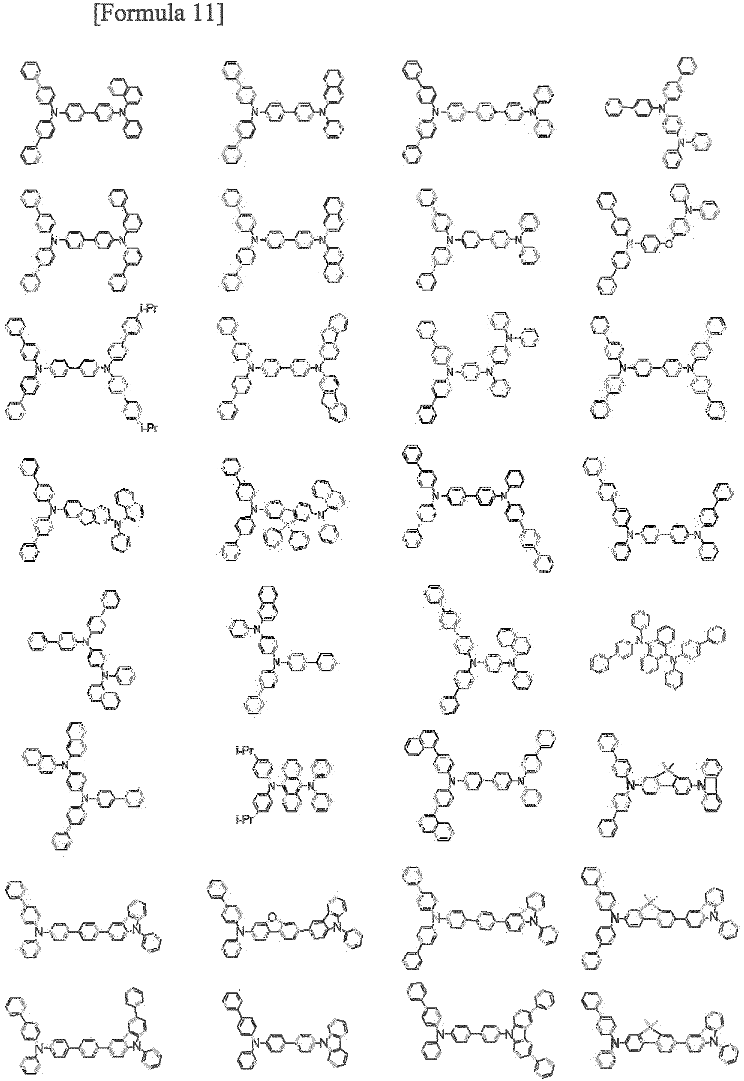

An amine derivative represented by the following formula (A2) is also preferable as the aromatic amine compound.

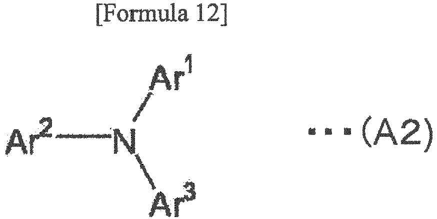

In the above formula (A2), Ar¹ to Ar³ each represent the same as Ar¹ to Ar⁴ of the above formula (Al). Examples of the compound represented by the formula (A2) are shown below. However, the compound represented by the formula (A2) is not limited thereto.

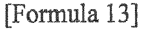

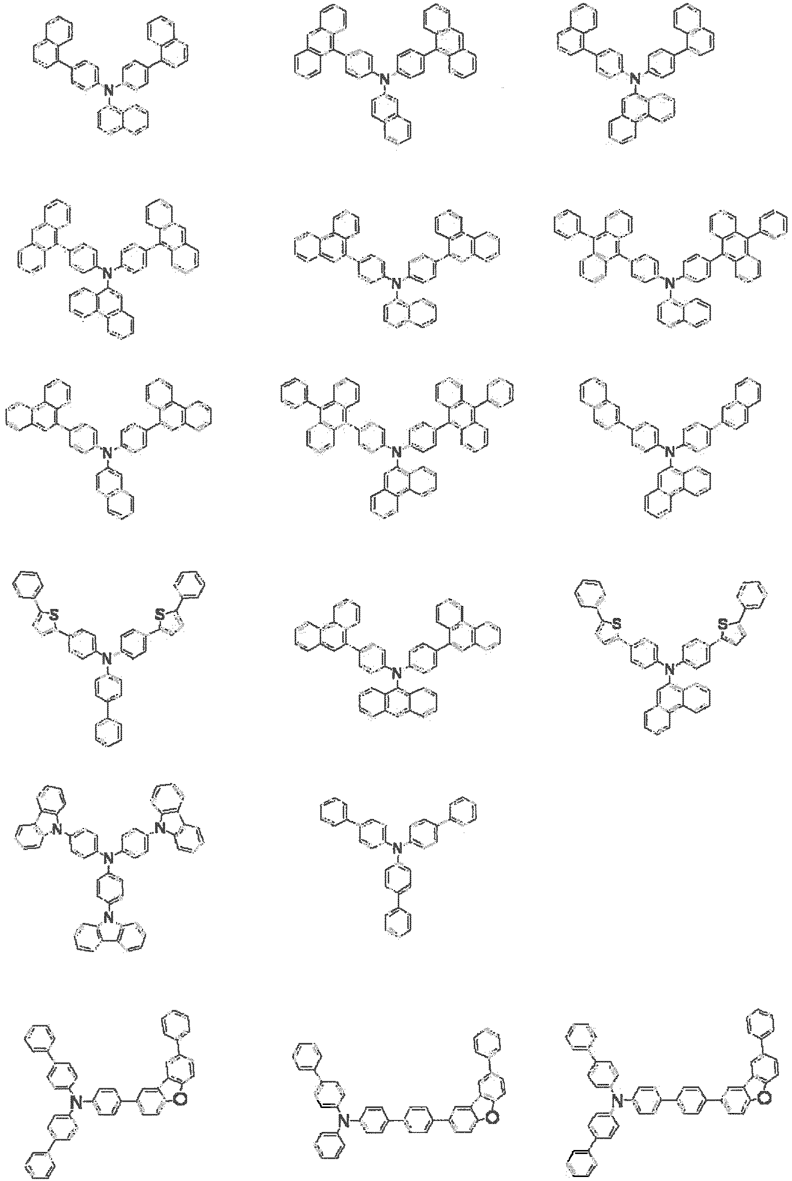

### Fused Polycyclic Compound

The fused polycyclic aromatic derivative is preferably a fused polycyclic aromatic hydrocarbon having no heterocyclic skeleton. Examples of the fused polycyclic aromatic derivative are the fused polycyclic aromatic hydrocarbon such as naphthalene, anthracene, phenanthrene, chrysene, fluoranthene and triphenylene, or derivatives thereof.

The hole injecting layer may be provided in a mixture of metal oxide and the amine compound. Examples of the metal oxide include molybdenum oxide, tungsten oxide, vanadium oxide and rhenium oxide. Herein, a blending ratio of the amine compound to the metal oxide is preferably 1:99 to 50:50 by a mass ratio, more preferably 10:90 to 20:80.

### Carbon Layer

The hole injecting layer is preferably a carbon layer in an amorphous state or a carbon layer substituted by fluorine.

The carbon layer is preferably formed by reactive sputtering.

Moreover, the fluorine-substituted carbon layer is preferably formed by plasma polymerization.

By inserting the carbon layer, hole injection to the hole transporting layer is promoted to lead to a low voltage and a high efficiency of the device.

In addition, a porphyrin compound, a styrylamine compound, a stilbene derivative, a silazane derivative, a polysilane compound, an aniline copolymer, a conductive high-molecular weight oligomer and the like are usable as the hole injecting layer.

### First Emitting Unit and Second Emitting Unit

Next, the first emitting unit and the second emitting unit will be described. When the common content of the first emitting unit and the second emitting unit is described, the first emitting unit and the second emitting unit are occasionally simply referred to as emitting units.

The emitting units each includes at least one emitting layer.

The emitting units each may be formed of a single emitting layer, or may be provided by laminating a plurality of emitting layers.

The emitting units each may be provided not only by laminating the emitting layers but also by laminating layers used in a known organic EL device such as a hole injecting layer, a hole transporting layer, an electron injecting layer, an electron transporting layer and a blocking layer through the emitting layer.

### Emitting Layer

The emitting layer, which is formed of known emitting materials such as Alq₃, provides a single-color emission such as red, green, blue or yellow emission, and combined-color emission of red, green, blue and yellow emission (e.g., white-color emission). Emission colors of the emitting layers of the first emitting unit and the second emitting unit may be the same or different. Further, the emitting units each may be formed of a fluorescent material or a phosphorescent material. When the emitting units are provided in a combination of the fluorescent material and the phosphorescent material, the emitting units may be provided in a sequence of fluorescent emitting unit/phosphorescent emitting unit or phosphorescent emitting unit/fluorescent emitting unit.

Moreover, a doping system is generally used in the emitting layer. In this case, the emitting layer is an organic layer containing a host material and a dopant material. The host material generally promotes recombination of electrons and holes and transmits exciton energy generated by the recombination to the dopant material. The dopant material is preferably a compound having a high quantum efficiency. The dopant material receiving the exciton energy from the host material exhibits a high emitting performance.

### Dopant Material

The dopant is formed of known dopant materials selected from a dopant material generating fluorescent emission and a dopant material generating phosphorescent emission.

The dopant material generating fluorescent emission (hereinafter, occasionally referred to as a "fluorescent dopant material") is selected from the group consisting of a fluoranthene derivative, pyrene derivative, aryl acethylene derivative, fluorene derivative, boron complex, perylene derivative, oxadiazole derivative and anthracene derivative. The fluoranthene derivative, pyrene derivative and boron complex are preferable.

The dopant material generating phosphorescent emission (hereinafter, occasionally referred to as a "phosphorescent dopant material") preferably contains a metal complex. The metal complex preferably includes: a metal atom selected from iridium (Ir), platinum (Pt), osmium (Os), gold (Au), rhenium (Re) and ruthenium (Ru); and a ligand. Particularly, the ligand and the metal atom preferably form an ortho-metal bond.

The phosphorescent dopant material is preferably a compound containing a metal selected from iridium (Ir), osmium (Os) and platinum (Pt) because such a compound, which exhibits high phosphorescence quantum yield, can further enhance external quantum efficiency of the emitting device. The phosphorescent emitting material is more preferably a metal complex such as an iridium complex, osmium complex or platinum complex, among which an iridium complex and platinum complex are more preferable and ortho metalation of an iridium complex is the most preferable. Moreover, in terms of luminous efficiency and the like, the phosphorescent dopant material is preferably an organic metal complex formed of the ligand selected from the group consisting of phenyl quinoline, phenyl isoquinoline, phenyl pyridine, phenyl pyrimidine and phenyl imidazole.

Examples of the phosphorescent dopant material are shown below, but the phosphorescent dopant material is not limited thereto.

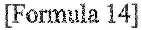

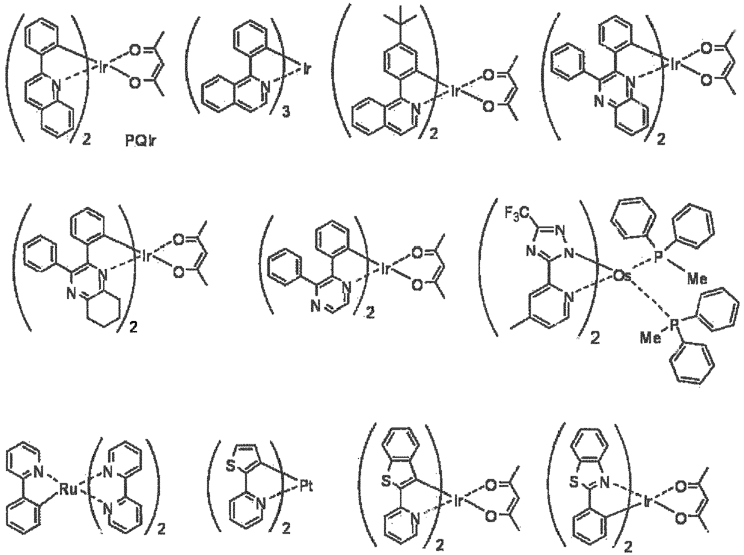

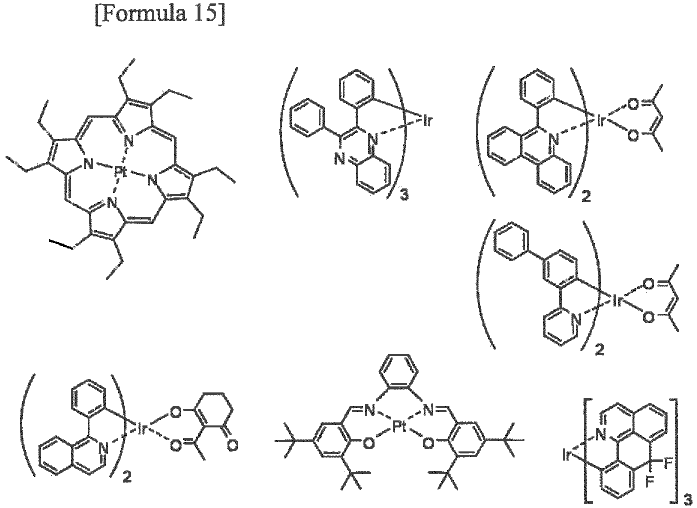

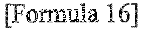

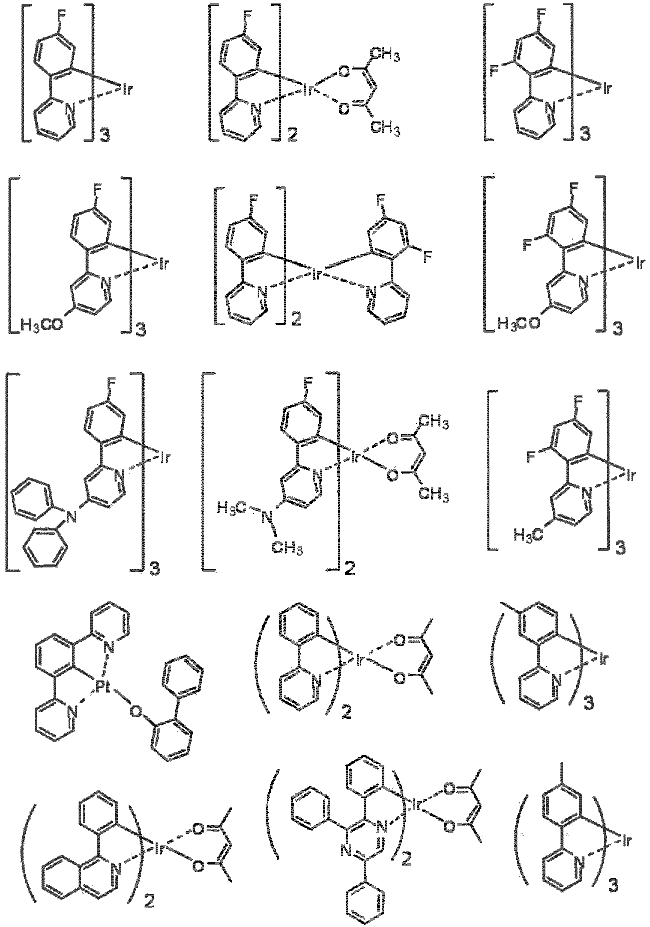

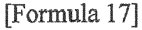

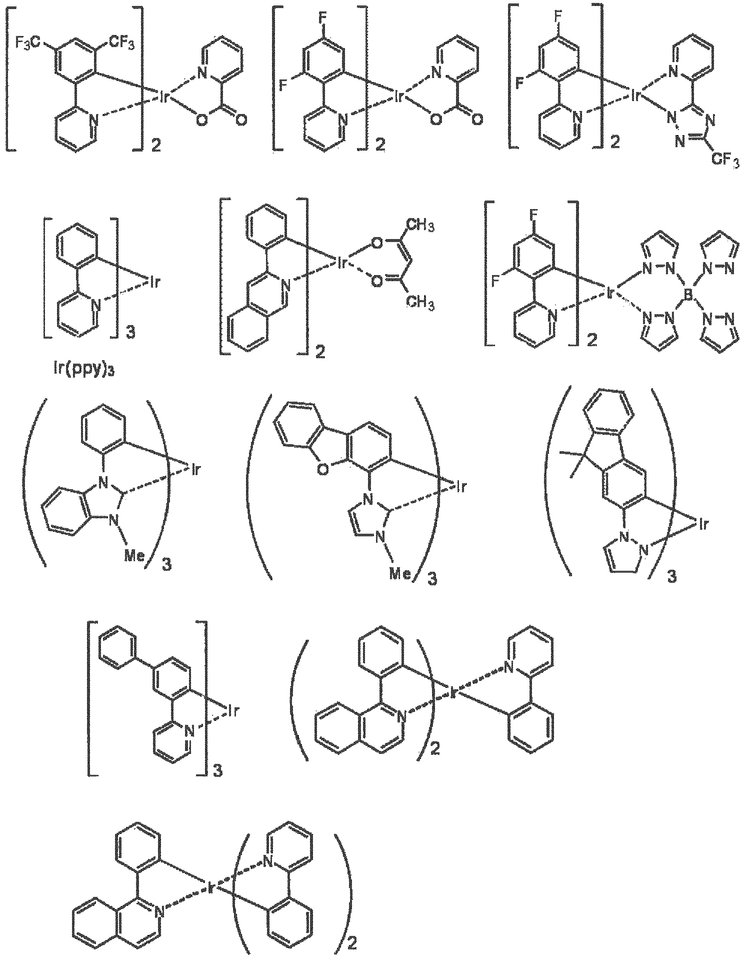

One kind of the dopant material may be singularly used, or two or more kinds thereof may be used in combination.

### Host Material

The host material, which is formed of known host materials, is exemplified by an amine derivative, azine derivative and fused polycyclic aromatic derivative.

Examples of the amine derivative include a monoamine compound, diamine compound, triamine compound, tetramine compound and amine compound substituted by a carbazole group.

Examples of the azine derivative include a monoazine derivative, diazine derivative and triazine derivative.

The fused polycyclic aromatic derivative is preferably a fused polycyclic aromatic hydrocarbon having no heterocyclic skeleton. Examples of the fused polycyclic aromatic derivative are the fused polycyclic aromatic hydrocarbon such as naphthalene, anthracene, phenanthrene, chrysene, fluoranthene and triphenylene, or derivatives thereof.

Specific examples of the phosphorescent dopant contained in the emitting layer include a carbazole derivative, triazole derivative, oxazole derivative, oxadiazole derivative, imidazole derivative, polyarylalkane derivative, pyrazoline derivative, pyrazolone derivative, phenylenediamine derivative, arylamine derivative, amino-substituted chalcone derivative, styryl anthracene derivative, fluorenone derivative, hydrazone derivative, stilbene derivative, silazane derivative, aromatic tertiary amine compound, styrylamine compound, aromatic dimethylidene compound, porphyrin compound, anthraquinodimethane derivative, anthrone derivative, diphenylquinone derivative, thiopyrandioxide derivative, carbodiimide derivative, fluorenylidenemethane derivative, distyryl pyrazine derivative, heterocyclic tetracarboxylic acid anhydride such as naphthaleneperylene, phthalocyanine derivative, various metal complex, polysilane compounds, poly(N-vinylcarbazole) derivative, aniline copolymer, conductive high-molecular weight oligomers and high-molecular weight compounds. Examples of the various metal complexes include a metal complex of 8-quinolynol derivative and a metal complex including metal phthalocyanine, benzoxazole and benzothiazole as a ligand. Examples of the conductive high-molecular weight oligomer include a thiophene oligomer and polythiophene. Examples of the high-molecular weight compound herein include a polythiophene derivative, polyphenylene derivative, polyphenylenevinylene derivative and polyfluorene derivative.

One of the host material may be used alone, or two or more thereof may be used in combination.

The emitting layers of the first emitting unit and the second emitting unit may contain a dopant material of the same emission type. Specifically, when the emitting layer of the first emitting unit contains a fluorescent dopant material, the emitting layer of the second emitting unit may contain a fluorescent dopant material. When the emitting layer of the first emitting unit contains a phosphorescent dopant material, the emitting layer of the second emitting unit may contain a phosphorescent dopant material.

Alternatively, the emitting layers of the first emitting unit and the second emitting unit may contain dopant materials of different emission type. Specifically, when one of the emitting layers contains the fluorescent dopant material, the other of the emitting layers contains the phosphorescent dopant material.

The combinations of the emission types of the dopants also apply to a case where three or more emitting units are laminated.

### Hole Injecting Layer and Hole Transporting Layer

The hole injecting layer in the intermediate unit is as described above. However, the hole injecting layer in the emitting unit mainly works as a layer for receiving holes from the anode and promoting injection of the holes to the emitting layer. The hole transporting layer mainly works as a layer for transporting the holes injected from the anode to the emitting layer and promoting injection of the holes to the emitting layer. The hole injecting layer and the hole transporting layer generally have a large hole mobility. Herein, when both of the hole injecting layer and the hole transporting layer are provided, the hole injecting layer is preferably closer to the anode.

When the first emitting unit has at least one of the hole injecting layer and the hole transporting layer, the hole injecting layer and/or the hole transporting layer is(are) interposed between the anode and the emitting layer of the first emitting unit. When the second emitting unit has at least one of the hole injecting layer and the hole transporting layer, the hole injecting layer and/or the hole transporting layer is(are) interposed between the hole injecting layer in the intermediate unit and the emitting layer of the second emitting unit.

The hole injecting layer and the hole transporting layer each may be formed in a laminate of two or more layers, or may be formed of a mixture of two or more materials.

The hole injecting layer and the hole transporting layer may be formed of the compound described for the hole injecting layer in the intermediate unit.

### Electron Injecting Layer and Electron Transporting Layer

The electron transporting layer mainly works as a layer for receiving electrons from the anode and promoting injection of the electrons to the emitting layer. The electron transporting layer mainly works as a layer for transporting the electrons injected from the anode to the emitting layer and promoting injection of the electrons to the emitting layer. The electron injecting layer and the electron transporting layer generally have a large electron mobility. When both of the electron injecting layer and the electron transporting layer are provided, the electron injecting layer is preferably closer to the cathode.

When the emitting unit has at least one of the electron injecting layer and the electron transporting layer, the electron injecting layer and/or the electron transporting layer is(are) interposed between the emitting layer of the first emitting unit and the inorganic-compound-containing layer of the intermediate unit in the first emitting unit. In the second emitting unit, the electron injecting layer and/or the electron transporting layer is(are) interposed between the emitting layer of the second emitting unit and the cathode. The electron transporting layer adjacent to the intermediate unit transports the electrons supplied from the inorganic-compound-containing layer to the emitting layer. The electron injecting layer and the electron transporting layer each may be formed in a laminate of two or more layers, or may be formed of a mixture of two or more materials.

In the first emitting unit, the electron transporting layer is preferably interposed between the emitting layer of the first emitting unit and the inorganic-compound-containing layer of the intermediate unit. The electron transporting layer promotes transporting the electrons injected from the inorganic-compound-containing layer of the intermediate unit to the emitting layer and contributes to lowering drive voltage and improving luminous efficiency of the device.

The electron transporting layer is preferably formed of an electron transporting material. The electron transporting material is preferably a nitrogen-containing ring compound. Examples of the electron transporting material are compounds disclosed in International Publication No. WO04/080975, JP-A-2007-153778 and JP-A-2001-267080. In addition, known materials used for the electron transporting layer and the electron injecting layer are also listed. For instance, an aromatic heterocyclic compound having one or more heteroatoms in a molecular is listed, among which a nitrogen-containing cyclic derivative is particularly preferable. The nitrogen-containing cyclic derivative is preferably an aromatic ring having a nitrogen-containing six-membered or five-membered ring skeleton, or a fused aromatic cyclic compound having a nitrogen-containing six-membered or five-membered ring skeleton. The nitrogen-containing cyclic derivative is preferably a nitrogen-containing cyclic metal chelate complex.

For instance, the nitrogen-containing cyclic metal chelate complex is preferably a compound represented by the following formula (B1).

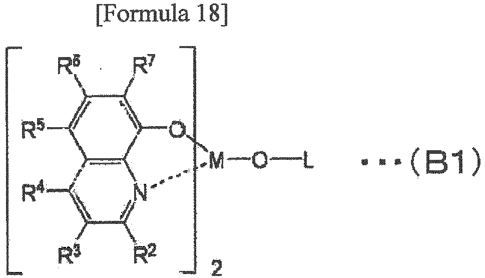

In the formula (B1), R² to R⁷ independently represent a hydrogen atom, a halogen atom, an oxy group, an amino group, a hydrocarbon group having 1 to 40 carbon atoms, an alkoxy group, an aryloxy group, an alkoxycarbonyl group, or an aromatic heterocyclic group, which may be mutually the same or different and may be substituted.

Examples of the halogen atom are fluorine, chlorine, bromine and iodine. In addition, examples of the substituted or unsubstituted amino group include an alkylamino group, an arylamino group, and an aralkylamino group.

The alkoxycarbonyl group is represented by -COOY'. Examples of Y' are the same as the examples of the alkyl group. The alkylamino group and the aralkylamino group are represented by -NQ¹Q². Examples for each of Q¹ and Q² are the same as the examples described in relation to the alkyl group and the aralkyl group (i.e., a group obtained by substituting a hydrogen atom of an alkyl group with an aryl group), and preferable examples for each of Q¹ and Q² are also the same as those described in relation to the alkyl group and the aralkyl group. One of Q¹ and Q² may be a hydrogen atom. Note that the aralkyl group is a group obtained by substituting the hydrogen atom of the alkyl group with the aryl group.

The arylamino group is represented by -NAr¹Ar². Examples of each of Ar¹ and Ar² are the same as the examples described in relation to the non-fused aromatic hydrocarbon group and the fused aromatic hydrocarbon group. One of Ar¹ and Ar² may be a hydrogen atom.

M represents aluminium (Al), gallium (Ga) or indium (In), among which In is preferable.

L in the formula (B1) represents a group represented by a formula (B2) or (B3) below.

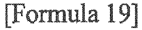

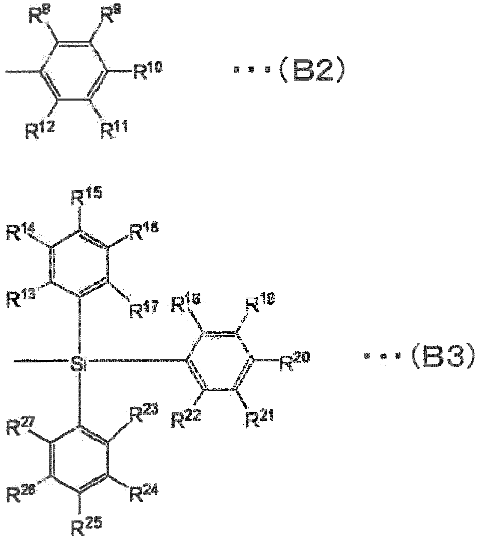

In the formula (B2), R⁸ to R¹² represent a hydrogen atom or a hydrocarbon group having 1 to 40 carbon atoms, which may be mutually the same or different. Adjacent groups may form a cyclic structure. The hydrocarbon group may have a substituent.

In the formula (B3), R¹³ to R²⁷ represent a hydrogen atom or a hydrocarbon group having 1 to 40 carbon atoms, which may be mutually the same or different. Adjacent groups may form a cyclic structure. The hydrocarbon group may have a substituent.

Examples of the hydrocarbon group having 1 to 40 carbon atoms represented by each of R⁸ to R¹² and R¹³ to R²⁷ in the formulae (B2) and (B3) are the same as those of R² to R⁷ in the formula (B1).

Examples of a divalent group formed when adjacent groups of R⁸ to R¹² and R¹³ to R²⁷ form a cyclic structure are a tetramethylene group, a pentamethylene group, a hexamethylene group, a diphenylmethane-2,2'-diyl group, a diphenylethane-3,3'-diyl group and a diphenylpropane-4,4'-diyl group.

The nitrogen-containing cyclic derivative is preferably a compound represented by the following formulae (B4) to (B6).

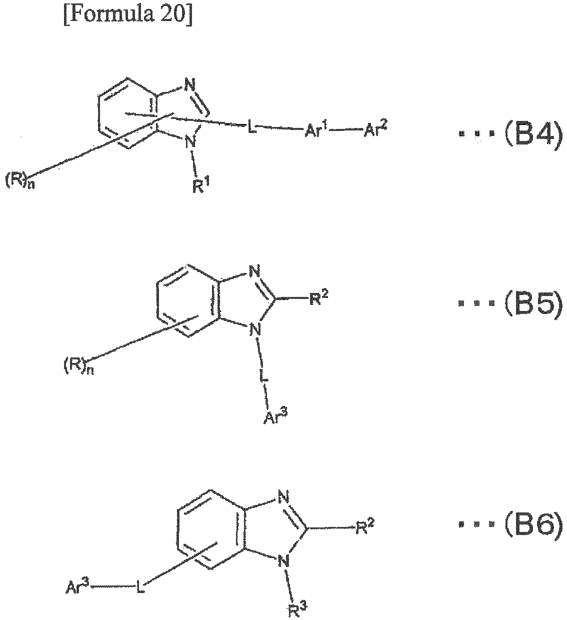

In the formulae (B4) to (B6), R represents a hydrogen atom, an aromatic hydrocarbon group having 6 to 60 ring carbon atoms, a fused aromatic hydrocarbon group having 6 to 60 ring carbon atoms, a pyridyl group, a quinolyl group, an alkyl group having 1 to 20 carbon atoms, or an alkoxy group having 1 to 20 carbon atoms.
n is an integer in a range of 0 to 4.

In the formulae (B4) to (B6), R¹ represents an aromatic hydrocarbon group having 6 to 60 ring carbon atoms, a fused aromatic hydrocarbon group having 6 to 60 ring carbon atoms, a pyridyl group, a quinolyl group, an alkyl group having 1 to 20 carbon atoms, or an alkoxy group having 1 to 20 carbon atoms.

In the formulae (B4) to (B6), R² and R³ represent a hydrogen atom, an aromatic hydrocarbon group having 6 to 60 ring carbon atoms, a fused aromatic hydrocarbon group having 6 to 60 ring carbon atoms, a pyridyl group, a quinolyl group, an alkyl group having 1 to 20 carbon atoms, or an alkoxy group having 1 to 20 carbon atoms, which may be mutually the same or different.

In the formulae (B4) to (B6), L represents an aromatic hydrocarbon group having 6 to 60 ring carbon atoms, a fused aromatic hydrocarbon group having 6 to 60 ring carbon atoms, a pyridinylene group, a quinolinylene group, or a fluorenylene group.

In the formulae (B4) to (B6), Ar¹ represents an aromatic hydrocarbon group having 6 to 60 ring carbon atoms, a fused aromatic hydrocarbon group having 6 to 60 ring carbon atoms, a pyridinylene group, or a quinolinylene group.

In the formulae (B4) to (B6), Ar² represents an aromatic hydrocarbon group having 6 to 60 ring carbon atoms, a fused aromatic hydrocarbon group having 6 to 60 ring carbon atoms, a pyridyl group, a quinolyl group, an alkyl group having 1 to 20 carbon atoms, or an alkoxy group having 1 to 20 carbon atoms.

In the formulae (B4) to (B6), Ar³ represents an aromatic hydrocarbon group having 6 to 60 ring carbon atoms, a fused aromatic hydrocarbon group having 6 to 60 ring carbon atoms, a pyridyl group, a quinolyl group, an alkyl group having 1 to 20 carbon atoms, an alkoxy group having 1 to 20 carbon atoms, or a group represented by -Ar¹-Ar² in which Ar¹ and Ar² are the same as the above.

The fused aromatic hydrocarbon group, pyridyl group, fused aromatic hydrocarbon group, pyridyl group, quinolyl group, alkyl group, alkoxy group, pyridinylene group, quinolinylene group and fluorenylene group which are described in relation to R, R¹, R², R³, L, Ar¹, Ar² and Ar³ in the formulae (B4) to (B6) may have a substituent.

The electron transporting layer may contain a reduction-causing substance. Examples of the reduction-causing substance include alkali metal, alkaline-earth metal, rare earth metal, alkali metal complex, alkaline-earth metal complex, rare earth metal complex, halogenated alkali metal, halogenated alkaline-earth metal and halogenated rare earth metal. In other words, the electron transporting layer is a layer (so-called N-doped layer) provided by blending the electron transporting material and the reduction-causing substance.

The electron injecting layer is preferably formed of the aforementioned electron transporting material and an electron donating material. The electron injecting layer may be provided in a mixture of the electron transporting material and the electron donating material. The electron donating material interacts with another organic material contained in the electron injecting layer, or with an organic material forming a layer adjacent to the electron injecting layer, thereby generating radical anions or providing electron-donating radicals.

Specific examples of the electron donating material are alkali metal, an alkali metal compound, an alkaline-earth metal, an alkaline-earth metal compound and an organic electron donating compound.

Examples of alkali metal are Li, Na, K, Rb, and Cs.

Examples of the alkali metal compound are an alkali metal oxide such as lithium oxide (Li₂O) and an alkali metal carbonate such as lithium carbonate (Li₂CO₃).

Examples of alkaline-earth metal are Ca, Mgreen, Ba, and Sr.

Examples of the alkaline-earth metal compound are an alkaline-earth metal oxide such as calcium oxide (CaO), an alkaline-earth metal carbonate such as calcium carbonate (CaCO₃) and calcium fluoride (CaF2) used in the intermediate layer.

Examples of the organic electron donating compound are an organic metal complex including alkali metal such as lithium quinolinolate (Liq) and compounds disclosed in JP-A-2007-314513, JP-A-2009-530836, JP-A-2007-273978, JP-A-2010-510645 and JP-A-2010-510179.

### Substrate

The organic EL device according to the exemplary embodiment of the invention is formed on a light-transmissive substrate. The light-transmissive substrate, which supports the anode, the organic compound layer and the cathode forming the organic EL device, is preferably a smooth and flat substrate that transmits 50 % or more of light in a visible region of 400 nm to 700 nm.

The light-transmissive plate is exemplarily a glass plate, a polymer plate or the like.

The glass plate is formed of soda-lime glass, barium/strontium-containing glass, lead glass, aluminosilicate glass, borosilicate glass, barium borosilicate glass, quartz, and the like.

For the polymer plate, materials such as polycarbonate, acryl, polyethylene terephthalate, polyether sulfide and polysulfone can be used.

### Anode and Cathode

The anode of the organic EL device is used for injecting holes into the emitting layer. It is effective that the anode has a work function of 4.5 eV or more.

Specific examples of a material for the anode are alloys of indium-tin oxide (ITO), tin oxide (NESA), indium zinc oxide, gold, silver, platinum and copper.

When light from the emitting layer is to be extracted through the anode, the anode preferably transmits more than 10% of the light in the visible region. Sheet resistance of the anode is preferably several hundreds Ω/ square or lower. Although depending on the material for the anode, a thickness of the anode is typically selected in a range of 10 nm to 1 µm, and preferably in a range of 10 nm to 200 nm.

The cathode is preferably formed of a material with smaller work function in order to inject electrons into the emitting layer.

Although a material for the cathode is not particularly limited, examples of the material are indium, aluminium, magnesium, alloy of magnesium and indium, alloy of magnesium and aluminium, alloy of aluminium and lithium, alloy of aluminium, scandium and lithium, and alloy of magnesium and silver.

Similar to the anode, the cathode may be manufactured by forming a thin film on the electron transporting layer or the electron injecting layer by a method such as vapor deposition. In addition, the light from the emitting layer may also be extracted through the cathode. When the light from the emitting layer is to be extracted through the cathode, the cathode preferably transmits more than 10% of the light in the visible region.

Sheet resistance of the cathode is preferably several hundreds Ω per square or lower.

Although depending on the material for the cathode, a thickness of the cathode is typically selected in a range of 10 nm to 1 µm, preferably in a range of 50 nm to 200 nm.

Although the thickness of each organic layer of the organic EL device is not particularly limited except for the above description, the thickness is generally preferably in a range of several nanometers to 1 µm because an excessively-thinned film likely entails defects such as a pin hole while an excessively-thickened film requires high voltage to be applied and deteriorates efficiency.

### Manufacturing Method of Organic EL Device

In manufacturing the organic EL device according to the exemplary embodiment of the invention, the metal layer of the intermediate unit is preferably formed by resistance heating deposition or electron beam vapor deposition. Firstly, the anode and the layers of the first emitting unit are sequentially formed on the substrate. Next, the inorganic-compound-containing layer is formed on the first emitting unit. The metal layer is formed on the inorganic-compound-containing layer by vapor deposition. When the metal layer is formed by a plurality of metals, the metal layer is formed by co-vapor deposition. After the metal layer is formed, the layers of the second emitting unit and the cathode are formed. Subsequently, each of the layers on the substrate is preferably sealed by a sealing member.

A method for forming the inorganic-compound-containing layer, the anode, the cathode, and the layers of the emitting unit is not particularly limited. Any typical manufacturing methods for organic EL devices are usable. Specific examples for forming the respective layers on the substrate are vapor deposition, a sputtering method, an ion plating method, a casting method, a coating method, a spin coating method, a dipping method, and an inkjet method.

Moreover, in addition to the casting method, the coating method and the spin coating using a solution, in which the organic material of the layers are dispersed, on a transparent polymer such as polycarbonate, polyurethane, polystyrene, polyarylate and polyester, the respective layers can be formed by simultaneous deposition with the organic material and the transparent polymer.

### Second Exemplary Embodiment

Next, a second exemplary embodiment is described below.

In the description of the second exemplary embodiment, the same components as those in the first exemplary embodiment are denoted by the same reference signs and names to simplify or omit an explanation of the components. In the second exemplary embodiment, the same materials and compounds as described in the first exemplary embodiment are usable.

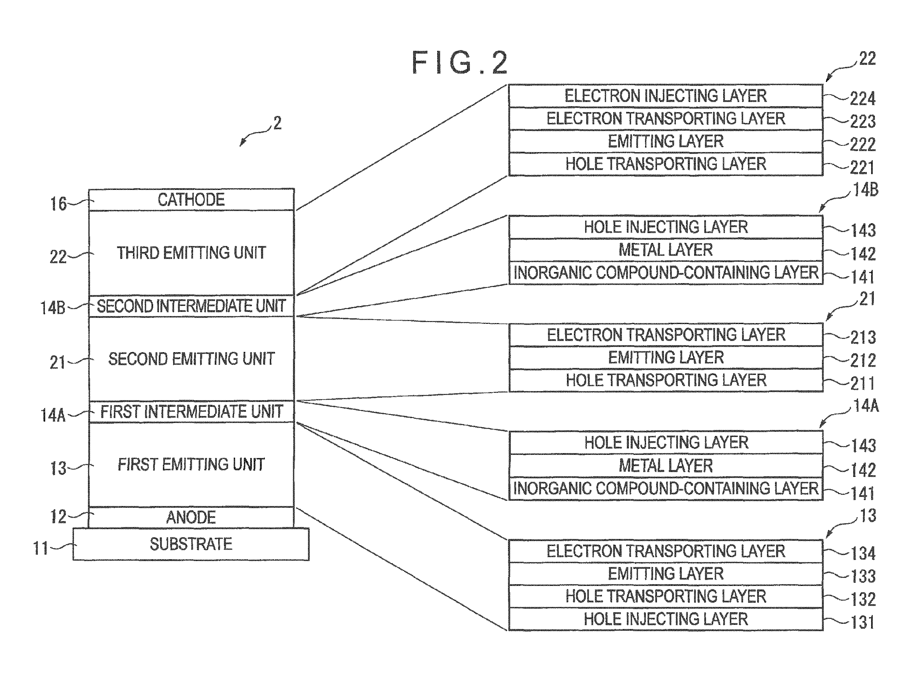

As shown in Fig. 2, an organic EL device 2 according to the second exemplary embodiment includes three emitting units and two intermediate units.

The organic EL device 2 is provided by laminating the anode 12, the first emitting unit 13, a first intermediate unit 14A, the second emitting unit 21, a second intermediate unit 14B, a third emitting unit 22 and the cathode 16 on the substrate 11 in this sequence.

In the second exemplary embodiment, the first intermediate unit 14A and the second intermediate unit 14B each include the inorganic-compound-containing layer, the metal layer and the hole injecting layer in the same manner as in the first exemplary embodiment. The first intermediate unit 14A injects electrons to the first emitting unit 13 and injects holes to the second emitting unit 21. The second intermediate unit 14B injects electrons to the second emitting unit 21 and injects holes to the third emitting unit 22.

The first emitting unit 13 in the second exemplary embodiment is basically the same as that described in the first exemplary embodiment.

Unlike in the first exemplary embodiment, the second emitting unit 21 is arranged in the same manner as the first emitting unit 13. The second emitting unit 21 is sequentially arranged from the first intermediate unit 14A as follows.

The second emitting unit 21 includes a hole transporting layer 211, an emitting layer 212, and an electron transporting layer 213.

The third emitting unit 22 is sequentially arranged from the second intermediate unit 14B as follows.

The third emitting unit 22 includes a hole transporting layer 221, an emitting layer 222, an electron transporting layer 223, and an electron injecting layer 224.

Since the organic EL device 2 in the second exemplary embodiment is laminated with additional ones of the emitting unit and the intermediate unit as compared to the first exemplary embodiment, the organic EL device 2 exhibits higher luminous efficiency than the organic EL device 1.

### Third Exemplary Embodiment

Next, a third exemplary embodiment is described below.

In the description of the third exemplary embodiment, the same components as those in the first exemplary embodiments are denoted by the same names and the like to simplify or omit an explanation of the components. In the third exemplary embodiment, the same materials and compounds as described in the first exemplary embodiment are usable.

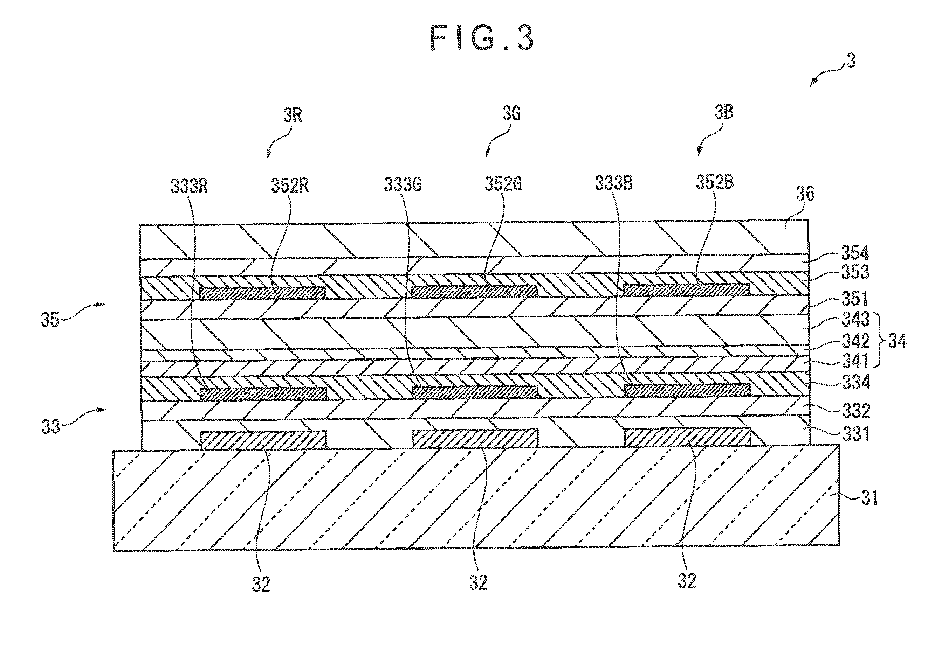

An organic EL device 3 according to the third exemplary embodiment is arranged to be capable of emitting light by three primary colors (RGB): red (R), green (G) and blue (B). As shown in Fig. 3, a red emitting device 3R (red pixel), a green emitting device 3G (green pixel) and a blue emitting device 3B (blue pixel) are formed on a common substrate 31.

The organic EL device 3 is provided by laminating an anode 32, first emitting unit 33, intermediate unit 34, second emitting unit 35 and cathode 36 on a substrate 31 in this sequence. The first emitting unit 33 and the second emitting unit 35 each include the emitting layers capable of emitting light in colors of RGB as described below. Layers except for the emitting layers are common to the red emitting device 3R, the green emitting device 3G and the blue emitting device 3B.

The first emitting unit 33 is provided by laminating a hole injecting layer 331, a hole transporting layer 332, emitting layers (a red emitting layer 333R, a green emitting layer 333G and a blue emitting layer 333B) and an electron transporting layer 334 in this sequence from the anode 32.

The red emitting layer 333R, the green emitting layer 333G and the blue emitting layer 333B are formed on the hole transporting layer 332 in a partitioned manner. The emitting layers 333R, 333G and 333B are formed of a material suitably selected from the materials of the first exemplary embodiment so as to be capable of emitting red light, green light and blue light respectively.

The electron transporting layer 334 is formed on the emitting layers (the red emitting layer 333R, the green emitting layer 333G and the blue emitting layer 333B).

Thus, the hole injecting layer 331, the hole transporting layer 332 and the electron transporting layer 334 are common to the red emitting layer 333R, the green emitting layer 333G and the blue emitting layer 333B.

The intermediate unit 34 is interposed between the first emitting unit 33 and the second emitting unit 35 and is common to the red emitting device 3R, the green emitting device 3G and the blue emitting device 3B. The intermediate unit 34 includes an inorganic-compound-containing layer 341, a metal layer 342 and a hole injecting layer 343 and is formed of the same material as the material described in the first exemplary embodiment.

The second emitting unit 35 is provided by laminating a hole transporting layer 351, emitting layers (a red emitting layer 352R, a green emitting layer 352G and a blue emitting layer 352B), an electron transporting layer 353 and an electron injecting layer 354 in this sequence from the anode 32.

The hole transporting layer 351 is formed on the hole injecting layer 343 in the intermediate unit 34. The red emitting layer 352R, the green emitting layer 352G and the blue emitting layer 352B are formed on the hole transporting layer 551 in a partitioned manner. The emitting layers 352R, 352G and 352B are formed of a material suitably selected from the materials of the first exemplary embodiment so as to be capable of emitting red light, green light and blue light respectively. Further, the emitting layers 352R, 352G and 352B of the second emitting unit 35 each are formed at a position corresponding to a position of each of the respective emitting layers 333R, 333G and 333B in the first emitting unit 33. For instance, as shown in Fig. 3, the emitting layers are formed in a vertically superposed positions in a cross sectional view in a thickness direction of the substrate 31 of the organic EL device 3.

The electron transporting layer 353 is formed on the emitting layers 352R, 352G and 352B.

The electron injecting layer 355 is formed on the electron transporting layer 354.

Thus, the hole transporting layer 351, the electron transporting layer 353 and the electron injecting layer 354 are common to the red emitting layer 352R, the green emitting layer 352G and the blue emitting layer 352B.

From the above, the red emitting device 3R as red pixel is arranged as follows: substrate 31/anode 32/hole injecting layer 331/hole transporting layer 332/red emitting layer 333R/electron transporting layer 334/intermediate unit 34 (inorganic-compound-containing layer 341/metal layer 342/hole injecting layer 343)/hole transporting layer 351/red emitting layer 352R/electron transporting layer 353/electron injecting layer 354/cathode 36.

The green emitting device 3G (green pixel) and the blue emitting device 3B (blue pixel) are respectively provided by replacing the red emitting layers 333R and 352R of the red emitting layer 3R with the green emitting layers 332G and 352G and the blue emitting layers 333B and 352B.

Thus, the organic EL device 3 includes the emitting devices 3R, 3G and 3B and the intermediate unit 34 of which arrangement and materials are the same as those in the first exemplary embodiment. Accordingly, the emitting devices 3R, 3G and 3B can emit light at a high luminous efficiency. The organic EL device 3 with a high luminous efficiency and capable of color display is especially useful for color display is particularly useful as an emitting device for a color display and an illumination panel.

In the organic EL device 3, a method for forming the emitting layers 333R, 333G, 333B, 352R, 352G and 352B is exemplified by a mask deposition method, a coating method (ink-jet method) and a transfer method. Other layers are formed by the methods described in the first exemplary embodiment.

### Modifications of Embodiment(s)

It should be noted that the present invention is not limited to the above description but may include any modification as long as such modification stays within a scope and a spirit of the present invention.

The arrangement of the organic EL device in which two or three emitting units are laminated is described in the above exemplary embodiments, but the arrangement thereof is not limited thereto. Four or more emitting units may be laminated, in which and an intermediate unit is interposed every between the emitting units. The number of the emitting units is preferably 2 to 4, more preferably 2 or 3 in view easiness of interference control of light.

In the third exemplary embodiment, the organic EL device is arranged with RGB emitting layers that are located in the emitting unit in a partitioned manner, but the arrangement of the organic EL device is not limited thereto. For instance, by appropriately blending the emitting colors of the emitting layers of the emitting units 33 and 35 to provide a white emission and separately combining RGB color filters to the organic EL device 3, an organic EL device capable of RGB emission may be provided.

### Examples

### Example 1

A glass substrate (size: 25 mm × 75 mm × 1.1mm thick) having an ITO transparent electrode (manufactured by Asahi Glass Co., Ltd) was ultrasonic-cleaned in isopropyl alcohol for five minutes, and then UV/ozone-cleaned for 30 minutes. After the glass substrate having the transparent electrode line was cleaned, the glass substrate was mounted on a substrate holder of a deposition apparatus, so that a 5-nm thick film of a compound HI-1 was initially formed on a surface of the glass substrate where the transparent electrode line was provided so as to cover the transparent electrode. Subsequently, a 45-nm thick film of a compound HI-2 was formed by resistance heating deposition. The films of the compounds HI-1 and HI-2 were provided as a hole injecting layer of the first emitting unit.

Next, a 45-nm thick film of a hole transporting compound HT was formed on the hole injecting layer of the first emitting unit by resistance heating deposition. The film formed of the compound HT was provided as a hole transporting layer of the first emitting unit.

Further, a compound BH (a host material) and a compound BD (a dopant material) were co-deposited by resistance heating on the hole transporting layer of the first emitting unit to form a 30-nm thick co-deposition film. The concentration of the compound BD was 5 mass %. The co-deposition film was provided as an emitting layer of the first emitting unit.

On the emitting layer of the first emitting unit, a 5-nm thick film of an electron transporting compound ET-1 was formed by resistance heating deposition. Next, a 20-nm thick film of an electron transporting compound ET-2 was formed by resistance heating deposition. The films of the compounds ET-1 and ET-2 were provided as an electron transporting layer of the first emitting unit.

The unit including the hole injecting layer, the hole transporting layer, the emitting layer and the electron transporting layer was provided as the first emitting unit.

Subsequently, a 1-nm thick film of calcium fluoride (CaF₂) was formed as a calcium halide layer on the electron transporting layer of the first emitting unit by resistance heating deposition. Subsequently, a 3-nm thick film of aluminium was formed by resistance heating deposition. Further, a 5-nm thick film of the compound HI-1 was formed on aluminium film by resistance heating deposition and is provided as a hole injecting layer. The unit including the inorganic-compound-containing layer, the metal layer and the hole injecting layer was provided as an intermediate unit.

Further, a 35-nm thick film of the compound HI-2 was formed by resistance heating deposition. The film formed of the compound HI-2 was provided as a hole injecting layer of the second emitting unit.

A 45-nm thick film of the compound HT was formed on the hole injecting layer of the second emitting unit by resistance heating deposition. The HT film was provided as a hole transporting layer of the second emitting unit.

Subsequently, the compound BH (a host material) and a compound GD (a dopant material) were co-deposited by resistance heating on the hole transporting layer of the second emitting unit to form a 30-nm thick co-deposition film. The concentration of the compound GD was 10 mass %. The co-deposition film was provided as an emitting layer of the second emitting unit.

On the emitting layer of the second emitting unit, a 5-nm thick film of the electron transporting compound ET-1 was formed by resistance heating deposition. Next, a 20-nm thick film of the electron transporting compound ET-2 was formed by resistance heating deposition. The films of the compounds ET-1 and ET-2 were provided as an electron transporting layer of the second emitting unit.

Subsequently, a 1-nm thick film of calcium fluoride was formed as an electron injecting layer on the electron transporting layer of the second emitting unit by resistance heating deposition.

The unit including the hole injecting layer, the hole transporting layer, the emitting layer, the electron transporting layer and the electron injecting layer was provided as the second emitting unit.

Finally, metal aluminium (Al) was deposited by resistance heating on the electron injecting layer of the second emitting unit to form a 100-nm thick cathode.

The tandem-type organic EL device was manufactured by the above method.

Chemical formulae of the compounds used in Example 1 and compounds described in the following Examples and Comparatives are described below.

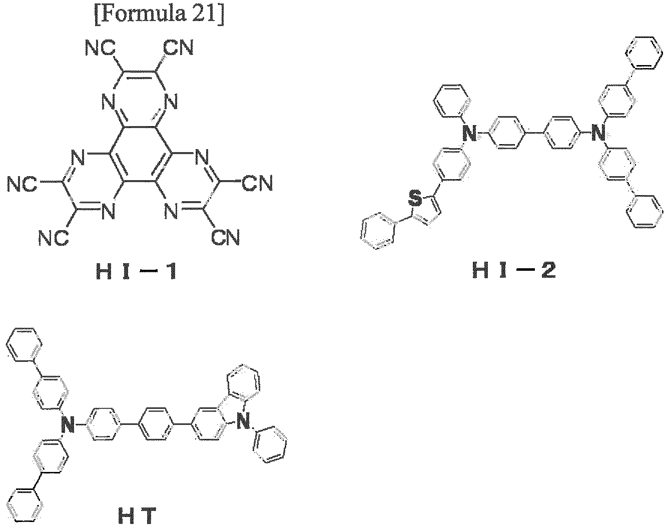

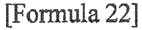

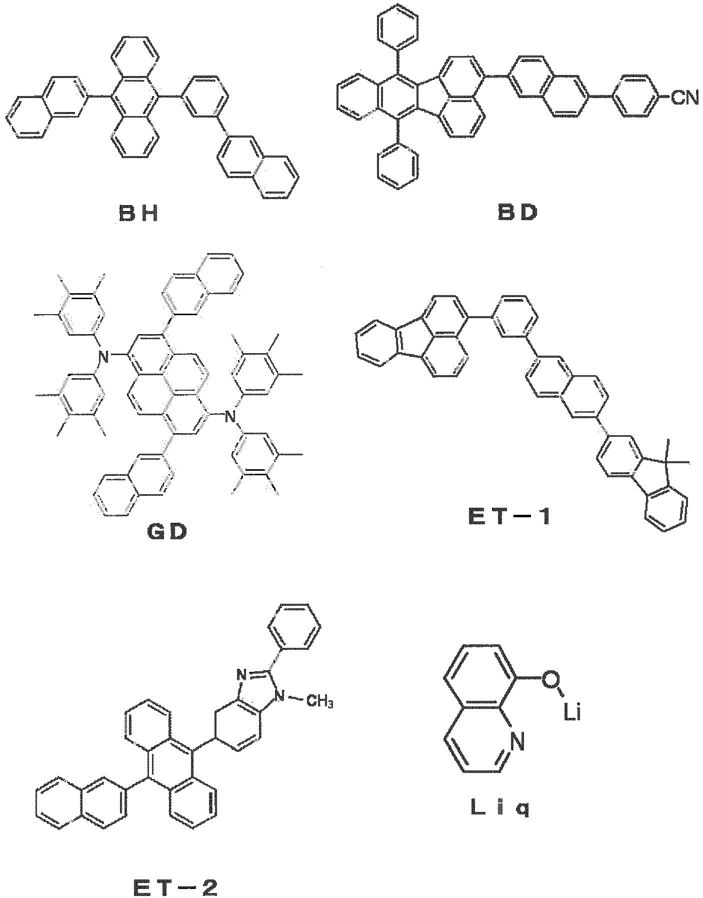

### Example 2

A tandem-type organic EL device in Example 2 was manufactured in the same manner as in Example 1 except that aluminium for the metal layer used in the intermediate unit was replaced by magnesium-silver alloy. Magnesium and silver were co-deposited by resistance heating. A blending ratio of the metals was 1:1 by mass.

### Example 3

An organic EL device in Example 3 was manufactured in the same manner as in Example 1 except that the electron transporting layer of each of the first and second emitting units was provided by a three-layered film including a 5-nm film of the compound ET-1, a 15-nm film of the compound ET-2, and a 5-nm blended film of the compound ET-2 and Liq. The blended film of the compound ET-2 and Liq was formed by resistance heating deposition. A blending ratio of the compound ET-2 and Liq was 1:1 by mass.

### Example 4

An organic EL device in Example 4 was manufactured in the same manner as in Example 2 except that the electron transporting layer of each of the first and second emitting units was provided by a three-layered film including a 5-nm film of the compound ET-1, a 15-nm film of the compound ET-2, and a 5-nm blended film of the compound ET-2 and Liq. The blended film of the compound ET-2 and Liq was formed by resistance heating deposition. A blending ratio of the compound ET-2 and Liq was 1:1 by mass.

### Example 5

An organic EL device of Example 5 was manufactured in the same manner as in Example 1 except that the compound HI-1 for the hole injecting layer of each of the first and second emitting units was replaced by a 5-nm amorphous carbon film. The amorphous carbon film was formed by DC magnetron sputtering using a carbon target under pressure of 3mTorr in nitrogen/argon mixture gas (N₂:2.5 vol%).

### Comparative 1

A device was manufactured in the same manner as in Example 2 except that calcium fluoride of the calcium halide layer was not provided.

### Comparative 2

A device was manufactured in the same manner as in Example 1 except that calcium fluoride was replaced by lithium fluoride (LiF) in the calcium halide layer.

### Reference Example 1

A glass substrate (size: 25 mm × 75 mm × 1.1mm thick) having an ITO transparent electrode (manufactured by Asahi Glass Co., Ltd) was ultrasonic-cleaned in isopropyl alcohol for five minutes, and then UV/ozone-cleaned for 30 minutes. After the glass substrate having the transparent electrode line was cleaned, the glass substrate was mounted on a substrate holder of a deposition apparatus, so that a 5-nm thick film of the compound HI was initially formed on a surface of the glass substrate where the transparent electrode line was provided so as to cover the transparent electrode. Subsequently, a 45-nm thick film of the compound HI-2 was formed by resistance heating deposition. The films of the compounds HI-1 and HI-2 were provided as a hole injecting layer.

Next, a 45-nm thick film of the hole transporting compound HT was formed by resistance heating deposition on the hole injecting layer adjacent to the anode. The HT film was provided as a hole transporting layer.

Further, the compound BH (the host material) and the compound BD (the dopant material) were co-deposited by resistance heating on the hole transporting layer to form a 30-nm thick co-deposition film. The concentration of the compound BD was 5 mass %. The co-deposition film was provided as an emitting layer.

On the emitting layer, a 5-nm thick film of the electron transporting compound ET-1 was formed by resistance heating deposition. Next, a 20-nm thick film of the electron transporting compound ET-2 was formed by resistance heating deposition. The films of the compounds ET-1 and ET-2 were provided as an electron transporting layer.

Further, a 1-nm thick film of calcium fluoride was formed as an electron injecting layer on the electron transporting layer.

Next, metal aluminium (Al) was formed on the electron injecting layer by resistance heating deposition to form a 100-nm thick cathode.

Specifically, in Reference Example 1, a single unit-type organic EL device was manufactured by excluding the intermediate unit from the first emitting unit and excluding the hole injecting layer, the hole transporting layer, the emitting layer and the electron transporting layer from the second emitting unit.

### Reference Example 2

A device was manufactured in the same manner as in Reference Example 1 except that calcium fluoride was replaced by lithium fluoride in the electron injecting layer.

### Evaluation of Organic EL Device

The prepared organic EL devices were evaluated in terms of drive voltage, CIE1931 chromaticity and external quantum efficiency EQE. The evaluation was conducted as follows.

The results of the evaluation are shown in Table 1.

### Drive Voltage

Electrical current was applied between ITO and Al such that a current density was 10.00 mA/cm², where voltage (unit: V) was measured.

### CIE1931 Chromaticity

Voltage was applied on each of the organic EL devices such that a current density was 10.00 mA/cm², where coordinates of CIE1931 chromaticity were measured by a spectroradiometer (CS-1000 manufactured by Konica Minolta Holdings, Inc.).

### Current Efficiency L/J

Voltage was applied on each of the organic EL devices such that a current density was 10.00 mA/cm², where spectral radiance spectrum was measured by the above spectroradiometer and a current efficiency (unit: cd/A) was calculated from the obtained spectral radiance spectrum.

### External Quantum Efficiency EQE

A voltage was applied on each of the devices such that a current value was 10.00 mA/cm², where spectral radiance spectrum was measured by the above spectroradiometer. The external quantum efficiency EQE (unit: %) was calculated based on the obtained spectral-radiance spectra, assuming that the spectra was provided under a Lambertian radiation.

**[Table 1]**

| | Voltage [V] | L/J [cd/A] | CIE-x | CIE-y | EQE [%] |
|---|---|---|---|---|---|
| Example 1 | 7.70 | 34.65 | 0.193 | 0.341 | 14.47 |
| Example 2 | 7.55 | 35.46 | 0.192 | 0.315 | 15.76 |
| Example 3 | 7.30 | 34.06 | 0.192 | 0.335 | 14.43 |
| Example 4 | 7.16 | 35.05 | 0.192 | 0.309 | 15.67 |
| Example 5 | 7.68 | 32.64 | 0.192 | 0.322 | 13.22 |
| Comparative 1 | 9.46 | 26.53 | 0.252 | 0.558 | 8.53 |
| Comparative 2 | 16.90 | 3.98 | 0.136 | 0.146 | 3.38 |
| Reference 1 | 3.77 | 8.93 | 0.148 | 0.118 | 8.44 |
| Reference 2 | 3.80 | 9.10 | 0.146 | 0.117 | 8.73 |

As shown in Table 1, the drive voltage, the current efficiency and the external quantum efficiency of the organic EL devices in Examples 1 to 5 were superior to those of Comparatives 1 and 2. This is because the luminous efficiency of the device was improved by efficient supply of holes and electrons to the emitting units adjacent to the intermediate unit since the intermediate unit was provided by laminating the inorganic-compound-containing layer and the metal layer in this sequence from the first emitting unit.

On the other hand, in the organic EL device in Comparative 1, the drive voltage was higher, and the current efficiency and the external quantum efficiency were lower than those of the organic EL devices in Examples 1 to 5. Moreover, both values of CIE-x and CIE-y were increased. This is because, without inserting calcium fluoride as the calcium halide layer, electrons were difficult to inject into the first emitting unit to cause increase in the drive voltage and decrease in the current efficiency and the external quantum efficiency and to relatively weaken blue emission of the first emitting unit.

In the organic EL device in Comparative 2, lithium fluoride generally used as the electron injecting layer was inserted in place of calcium fluoride, where the drive voltage was significantly increased, so that measurement of the drive voltage was difficult. This will be explained as follows. When the metal layer is deposited on the alkali metal compound layer and the alkaline-earth metal compound layer, the alkali metal compound layer and the alkaline-earth metal compound layer are thermally reduced. However, effects by the thermal reduction are different, where lithium fluoride is more difficult to thermally reduce than calcium fluoride. For this reason, it is considered that lithium fluoride could not be completely thermally reduced in the aluminium metal layer having a thickness as thin as 3 nm. This is also apparent from a fact that both of the device using calcium fluoride in the electron injecting layer and the device using lithium fluoride in the electron injecting layer emitted light at a low voltage when the cathode was provided by the aluminium metal layer having a thickness as thick as 100 nm, as shown in the evaluation results of the single unit-type organic EL device (an organic EL device without a plurality of emitting units) as Reference Example of Table 1.

The organic EL device of Reference Example 1 is an example of a single emitting unit in which calcium fluoride is used as the electron injecting layer. On the other hand, the organic EL device of Reference Example 2 is an example of a single emitting unit in which lithium fluoride is used as the electron injecting layer. In both of the organic EL devices, electrons are favorably injected from the cathode to exhibit favorable performance as the organic EL device.

It was understood from the above that, in the tandem-type organic EL device, electron injection to the first emitting unit and hole injection to the second emitting unit can be efficiently conducted by using the intermediate unit in which calcium halide and the metal layer are laminated, so that the organic EL device is driven at a low drive voltage and emits light at a high efficiency. In other words, it was understood that the arrangement of the intermediate unit is effective in the tandem-type organic EL device.

### INDUSTRIAL APPLICABILITY

A tandem-type organic EL device of the invention having a low drive voltage and emittable at a high efficiency is applicable to a display device, an illumination device and the like.

### EXPLANATION OF CODES

1, 2, 3: organic electroluminescence device (organic EL device)
12: anode
13, 33: first emitting unit
14, 34: intermediate unit
15, 21, 35: second emitting unit
16: cathode
143, 343: hole injecting layer

## Claims

1. A tandem-type organic electroluminescence device comprising:
an anode;
a cathode opposed to the anode;
at least a first emitting unit and a second emitting unit provided between the anode and the cathode, and
an intermediate unit provided between the first emitting unit and the second emitting unit, wherein
the intermediate unit comprises an inorganic-compound-containing layer and a metal layer sequentially layered from the anode, and
the inorganic-compound-containing layer comprises calcium halide.

2. An organic electroluminescence device comprising:
an anode;
a cathode opposed to the anode;
a first emitting unit provided between the anode and the cathode,
a second emitting unit provided between the anode and the cathode, and
an intermediate unit provided between the first emitting unit and the second emitting unit, wherein
the intermediate unit comprises an inorganic-compound-containing layer and a metal layer in this sequence from the anode, and
the inorganic-compound-containing layer comprises at least one calcium halide selected from the group consisting of calcium fluoride, calcium chloride and calcium bromide.

3. The organic electroluminescence device according to claim 1 or 2, wherein
the second emitting unit is provided adjacent to the intermediate unit near the cathode,
the intermediate unit further comprises a hole injecting layer between the metal layer and the second emitting unit,
the hole injecting layer is adjacent to the metal layer and the second emitting unit,
and
the hole injecting layer comprises an organic compound having an electron accepting group.

4. The organic electroluminescence device according to claim 3, wherein the hole injecting layer is at least one of a carbon layer in an amorphous state and a carbon layer substituted by fluorine.

5. The organic electroluminescence device according to claim 4, wherein the carbon layer is formed by reactive sputtering.

6. The organic electroluminescence device according to claim 4, wherein the carbon layer substituted by fluorine is formed by plasma polymerization.

7. The organic electroluminescence device according to any one of claims 1 to 6, wherein
the metal layer is formed of metal capable of thermally reducing the inorganic-compound-containing layer in a vacuum.

8. The organic electroluminescence device according to any one of claims 1 to 7, wherein
the metal layer is formed of metal selected from aluminium, magnesium and an alloy thereof.

9. The organic electroluminescence device according to any one of claims 1 to 8, wherein
the metal layer is formed on the inorganic-compound-containing layer by vapor deposition.
